# FASCICULE DE BREVET EUROPEEN

(11) **EP 3 144 973 B1**
(45) Date de publication et mention de la délivrance du brevet: **04.03.2020**
(21) Numéro de dépôt: 16189263.3
(22) Date de dépôt: 16.09.2016
(51) Int. Cl.: H01L 29/66, H01L 21/02, H01L 21/3115, H01L 29/786, H01L 21/311

(54) **PROCÉDÉ DE FORMATION DES ESPACEURS D'UNE GRILLE D'UN TRANSISTOR**
VERFAHREN ZUR BILDUNG VON ABSTANDHALTERN EINES GATES EINES TRANSISTORS
METHOD FOR FORMING SPACERS OF A TRANSISTOR GATE

(30) Priorité: 18.09.2015 FR 1558845
(43) Date de publication de la demande: 22.03.2017
(73) Titulaire: COMMISSARIAT À L'ÉNERGIE ATOMIQUE ET AUX ÉNERGIES ALTERNATIVES, 75015 Paris (FR)
(72) Inventeur: POLLET, Olivier, 38000 Grenoble (FR); POSSEME, Nicolas, 38360 Sassenage (FR)
(74) Mandataire: Hautier, Nicolas

(56) Documents cités:
- EP-A1- 2 876 677
- US-A- 4 749 440
- US-A1- 2006 057 828
- US-A1- 2007 235 411
- US-A1- 2014 076 849
- US-A1- 2014 199 851

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

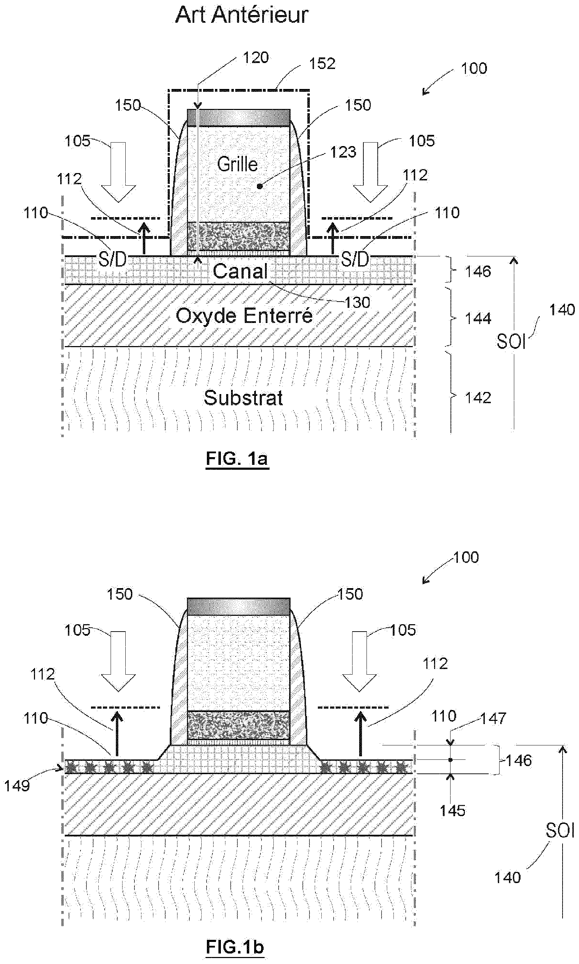

La **figure 1a** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

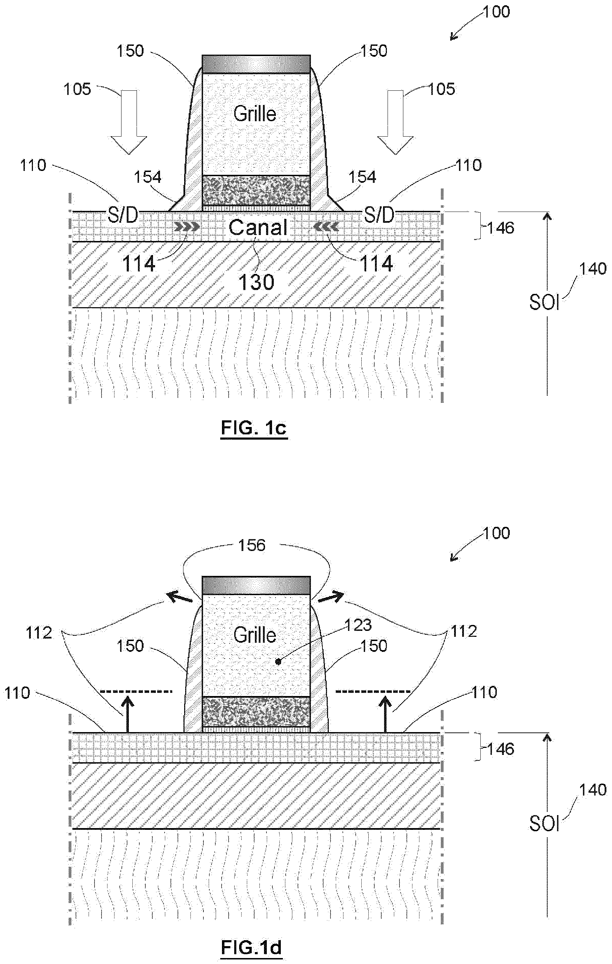

Les **figures 1b****,** **1c et 1d** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (O2). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4) qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482.

La **figure 1b** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 1c** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficielle de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 1d** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non-uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

De plus, pour certaines applications il peut être nécessaire de prévoir une couche de protection souvent à base de carbone telle un masque ou une résine photosensible (de l'anglais « photoresist ») ou thermosensible afin de protéger lors de la gravure des espaceurs des structures formées sur le substrat. Tel est par exemple le cas lors de la réalisation de transistors PMOS proches de transistors NMOS dont les espaceurs sont en cours de réalisation. Les procédés connus de gravure peuvent conduire à une forte consommation de cette couche de protection lors de la gravure des espaceurs du transistor PMOS.

D'autres solutions ont été proposées dans les documents US2014/0273292 et, FR12/62962. Ces solutions prévoient une étape d'implantation d'une couche de nitrure de silicium pour la modifier de part et d'autre de la grille, suivie d'une étape de retrait de la couche de nitrure de silicium modifiée.

Dans la solution FR12/62962 l'étape de retrait de la couche de nitrure modifiée peut être réalisée par un nettoyage humide à base d'acide fluorhydrique (HF). L'inconvénient est que le nettoyage humide à base de HF ne permet pas un retrait sélectif de la couche de nitrure modifiée vis-à-vis de la couche de nitrure non-modifiée. La sélectivité à la couche de nitrure non modifié est, par exemple, de 7 (pour une concentration de HF de 1%).

Par ailleurs l'acide fluorhydrique est un composé chimique dont l'une des principales propriétés est de graver l'oxyde de silicium, donc cette méthode est intrinsèquement non-sélective à la couche d'oxyde de silicium formant le masque dur ainsi que les tranchées d'isolation (en anglais acronyme STI pour « shallow trench isolation »). La sélectivité de cette couche d'oxyde au HF est, par exemple, de 1 (pour une concentration de HF de 1%).

D'autres solutions ont été proposées dans le domaine de la gravure. Le document EP2876677 concerne spécifiquement la gravure d'une couche poreuse. Il prévoit de modifier cette couche poreuse par implantation à partir d'un plasma d'argon, d'oxygène ou d'azote. Cette solution prévoit ensuite de retirer la couche modifiée soit par une gravure humide à base d'acide fluorhydrique, soit par une gravure sèche dans un plasma à base de NF3 et de NH3. Les documents US2014/199851 et US2006/057828 prévoient une gravure isotrope d'une couche de nitrure de silicium comprenant une étape d'implantation d'ions oxygène suivie d'une étape de gravure à base d'acide fluorhydrique en phase vapeur.

Ces différentes solutions ne permettent d'obtenir que des sélectivités de gravure limitées.

La présente invention a pour objet de proposer un procédé de formation d'espaceurs jouant pleinement leur rôle d'isolation et qui supprimerait ou limiterait au moins certains des défauts dans la réalisation de transistors, tels que la consommation ou l'altération du matériau semi-conducteur (i.e. Si, SiGe) de la couche active sous-jacente à la couche à graver, la formation de « pieds » au bas des motifs sur les flancs de la grille d'un transistor, la consommation d'une couche de protection à base de carbone, etc.

L'invention permet d'obtenir des espaceurs à base d'un matériau diélectrique tout en réduisant voire en éliminant les problèmes des solutions connues et mentionnés précédemment.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation d'espaceurs d'une grille d'un transistor à effet de champ, la grille comprenant des flancs et un sommet et étant située au-dessus d'une couche en un matériau semi-conducteur, le procédé comprenant une étape de formation d'une couche diélectrique recouvrant la grille du transistor, le procédé comprenant, après l'étape de formation de la couche diélectrique, au moins une étape de modification de ladite couche diélectrique par mise en présence de la couche diélectrique avec un plasma créant un bombardement d'ions légers anisotrope selon une direction privilégiée parallèle à des flancs de la grille, les conditions du plasma, en particulier l'énergie des ions légers et la dose implantée étant choisies de manière à modifier, par implantation des ions légers, au moins des portions de la couche diélectrique qui sont situées sur un sommet de la grille et de part et d'autre de la grille et qui sont perpendiculaires aux flancs de la grille en conservant des portions de la couche diélectrique recouvrant les flancs de la grille non-modifiées ou non-modifiées sur toute leur épaisseur; les ions légers étant des ions à base d'hydrogène et/ou à base d'hélium (He). Le procédé comprend également au moins une étape de retrait de la couche diélectrique modifiée à l'aide d'une gravure sélective de ladite couche diélectrique modifiée vis-à-vis de la couche en un matériau semi-conducteur et vis-à-vis de la couche diélectrique non modifiée.

Selon l'invention, l'étape de retrait de la couche diélectrique modifiée comprend une gravure sèche réalisée par mise en présence d'un mélange gazeux, de préférence uniquement gazeux, comprenant au moins un premier composant à base d'acide fluorhydrique (HF), l'acide fluorhydrique transformant en résidus non-volatiles, de préférence non-volatiles à température ambiante, la couche diélectrique modifiée.

Selon l'invention, l'étape de retrait de la couche diélectrique modifiée comprend, uniquement après la gravure sèche, un retrait des résidus non-volatiles à température ambiante par un nettoyage humide ou un recuit thermique de sublimation.

De manière particulièrement avantageuse, la présente invention permet une gravure fortement anisotrope et sélective de la couche diélectrique modifiée vis-à-vis d'une couche à base d'oxyde de silicium. La plage de variation des paramètres du procédé HF gazeux permettant d'obtenir une sélectivité de la couche diélectrique modifiée, par exemple à base de nitrure de silicium (SiN) par rapport à la couche diélectrique non modifiée, est plus étendue.

Un avantage de la présente invention est que la mise en présence peut être réalisée dans un simple réacteur chimique : une enceinte hermétique dans laquelle les réactifs sont introduits et qui fonctionne soit à température ambiante et pression atmosphérique, soit à température supérieure à l'ambiante et à pression inférieure à la pression atmosphérique. La mise en présence n'est donc avantageusement pas réalisée dans un réacteur plasma dont l'équipement et la gestion est plus complexe qu'un réacteur chimique. Ainsi, le HF gazeux est simple à mettre en oeuvre comparé à un plasma. En effet, un simple réacteur chimique, éventuellement régulé en pression et température, suffit. Dans le cas d'un plasma, il faudrait des générateurs RF et travailler à une pression beaucoup plus basse, donc l'équipement dans ce cas serait nettement plus complexe.

Avantageusement, le recuit thermique et la gravure HF sont effectués lors d'étapes successives et non simultanées. Cela permet d'éviter que la température nécessaire au recuit soit néfaste à l'adsorption du HF à la surface de la plaque, ce qui nuirait au déroulement de la réaction entre HF gazeux et la couche diélectrique modifiée, par exemple à base de SiN.

De manière particulièrement avantageuse, la présente invention permet non seulement un contrôle des dommages pouvant être engendrés suite à une implantation ionique, mais également une amélioration du retrait de la couche diélectrique modifiée, en proposant un procédé présentant une meilleure sélectivité de gravure entre la couche diélectrique modifiée et la couche diélectrique non modifiée d'une part, entre la couche diélectrique modifiée et la couche en oxyde de silicium et entre la couche diélectrique modifiée et la couche en un matériau semi-conducteur, d'autre part. Avantageusement, la sélectivité du procédé de HF gazeux entre la couche de diélectrique modifiée et la couche de matériau semiconducteur est infinie (autrement dit, le HF gazeux ne grave pas le matériau semiconducteur).

Avantageusement, la présente invention propose une sélectivité infinie de la couche diélectrique modifiée. Ainsi, la présente invention permet un meilleur contrôle des dimensions critiques. Le procédé selon la présente invention permet en outre une gravure sélective de la couche diélectrique modifiée au regard d'autres couches non modifiées par exemple, évitant tout risque de consommer tout ou partie d'une couche à base de nitrure de silicium ou une couche à base d'oxyde de silicium.

Dans la présente invention, le procédé est réalisé de façon séquentielle. La gravure, avantageusement « sèche », de la couche diélectrique modifiée, par exemple de nitrure de silicum (SiN), est effectuée à l'aide d'acide fluorhydrique gazeux pur (pas de co-injection d'alcool). A l'issue de la gravure sèche, des résidus non-volatiles à température ambiante (par exemple, sous forme de sels) sont présents au niveau de la couche diélectrique modifiée.

On entend par « sel », un composé solide ionique formé d'un anion et d'un cation mais dont la charge électrique globale est neutre.

Selon un premier mode de réalisation, les résidus de gravure non-volatiles peuvent alors être éliminés en effectuant un simple nettoyage humide à l'eau. Selon un autre mode de réalisation préféré mais non limitatif de l'invention, pour éliminer les résidus non-volatiles à la surface de la couche diélectrique modifiée, on effectue un recuit après la gravure « sèche » de la couche diélectrique modifiée. Ce recuit permet de sublimer les résidus non volatiles à température ambiante, typiquement des sels solides Cette méthode peut être utilisée, par exemple, en remplacement d'un nettoyage « humide », par exemple à base d'eau. Avantageusement, cette méthode (HF pur gazeux suivi d'un recuit) alternative propose un procédé entièrement « sec » (qui ne contient pas d'étapes en phase liquide), qui peut être intéressant pour éliminer les problèmes connus causés lors de gravures « humides » réalisées pour la formation de motifs, par exemple.

Selon un mode de réalisation avantageux, on réalise une étape de pré-recuit avant la gravure sèche à base d'acide fluorhydrique gazeux. Cela permet d'éliminer l'humidité naturellement adsorbée sur des substrats et évite ainsi d'introduire de l'eau, qui est un accepteur de protons, à l'intérieur de la chambre de traitement du graveur ; ladite chambre comprenant de l'acide fluorhydrique (HF). Ainsi l'étape de pré-recuit permet d'augmenter davantage la sélectivité entre une couche de nitrure de silicium modifiée (SiN) et une couche d'oxyde de silicium (SiO2).

Selon l'invention, aucune gravure d'une couche d'oxyde de silicium (SiO2) ne peut se produire puisque le procédé de gravure d'une couche à base d'oxyde de silicium ne fonctionne qu'avec la présence simultanée de l'acide fluorhydrique et de groupes accepteurs de protons (tels que l'alcool, l'eau). C'est donc par l'absence de mise en présence simultanée de l'acide fluorhydrique et de groupes accepteurs de protons, qu'est obtenue, de manière surprenante, une grande sélectivité entre une couche de nitrure de silicium (SiN) modifiée et une couche d'oxyde de silicium (SiO2), tout en permettant une gravure fortement anisotrope. La couche d'oxyde de silicium (SiO2) forme par exemple un masque dur ou des tranchées d'isolation.

Selon l'invention, la gravure sèche est réalisée par mise en présence d'un mélange gazeux exempt de groupes accepteurs de protons, comme par exemple de l'alcool ou de l'eau, par exemple sous forme de vapeur. Ainsi le mélange gazeux injecté ne comprend pas de groupements -OH. Selon un mode de réalisation, ce mélange gazeux comprend uniquement de l'acide fluorhydrique (HF).

De manière inattendue, ce processus séquentiel montre également une grande sélectivité entre une couche de nitrure de silicium (SiN) non modifiée et une couche de nitrure de silicium modifiée.

De manière particulièrement avantageuse, le procédé séquentiel selon la présente invention offre une meilleure sélectivité de gravure entre le silicium (Si) et le silicium-germanium (SiGe), notamment grâce à la sélectivité infinie intrinsèque de l'acide fluorhydrique envers ces matériaux. Ce procédé présente également une meilleure sélectivité de gravure entre l'oxyde de silicium (SiO2) formant par exemple le masque dur et le nitrure de silicium (SiN) non-modifié, notamment grâce à l'absence de groupes accepteurs de protons en utilisant un procédé à base d'acide fluorhydrique gazeux pur. D'autres solutions connues pour enlever une couche de nitrure de silicium SiN modifiée telles que l'acide fluorhydrique (HF) en phase liquide ou l'acide phosphorique (H3PO4) ne permettent pas une telle sélectivité envers, respectivement, l'oxyde de silicium (SiO2) ou le nitrure de silicium (SiN) non modifié.

Avantageusement, les paramètres de l'étape de retrait de la couche diélectrique modifiée, notamment le ratio de gaz entre le premier composant et le deuxième composant utilisé lors de la gravure sèche, sont prévus de sorte à ce que la couche diélectrique modifiée puisse être gravée de manière sélective vis-à-vis de la couche en un matériau semi-conducteur et vis-à-vis de la couche diélectrique non modifiée et, avantageusement, vis-à-vis de la couche en oxyde de silicium. Il est donc important de trouver un juste ratio entre la teneur en premier composant et en deuxième composant lors de la gravure sèche destinée à retirer la couche diélectrique modifiée. Avantageusement, le ratio de gaz entre le premier composant (par exemple, HF gazeux) et le deuxième composant (par exemple, N2 pur) est compris entre 1 :25 et 1 :1.
Un ratio inférieur, ce qui serait le cas si l'on réduit le débit du premier composant, aurait pour conséquence de limiter l'efficacité de la gravure de la couche diélectrique modifiée. Un ratio supérieur, ce qui serait le cas si l'on augmente le débit du premier composant, aurait pour conséquence de limiter la sélectivité vis-à-vis de la couche en nitrure de silicium non-modifiée et vis-à-vis de la couche en oxyde de silicium. Dans la présente demande de brevet, on entend par ratio entre deux composants gazeux, un ratio portant sur les débits respectifs d'introduction des composants dans l'enceinte du réacteur chimique (lors de l'utilisation de HF gazeux). Chaque débit se mesure habituellement en centimètre cube par minute (sccm). Typiquement un débit se mesure avec un débitmètre associé à chaque flux de gaz entrant dans le réacteur.

Avantageusement, la gravure sèche consomme la couche diélectrique modifiée préférentiellement à la couche en un matériau semi-conducteur et à la couche diélectrique non modifiée. Ainsi, le risque de consommation excessive de la couche superficielle de matériau semi-conducteur est réduit, voire supprimé.

Selon un mode de réalisation préférentiel, la gravure de la couche diélectrique est réalisée à l'aide d'une chimie sans carbone. Cela permet avantageusement d'éviter le dépôt d'une couche carbonée pouvant entraver la gravure de la couche diélectrique.

De manière facultative, le procédé peut en outre présenter au moins l'une quelconque des caractéristiques et étapes ci-dessous.
- Selon un mode de réalisation, la gravure sèche est réalisée par mise en présence d'un mélange gazeux comprenant uniquement de l'acide fluorhydrique (HF) et éventuellement un gaz inerte.
- Selon un mode de réalisation, la gravure sèche est réalisée par mise en présence d'un mélange gazeux comprenant uniquement un premier composant à base d'acide fluorhydrique.
- De préférence, le HF gazeux est disponible en bouteille et peut donc être directement injecté dans le réacteur après détente à la pression à laquelle le réacteur fonctionne. Le HF gazeux peut aussi être généré par évaporation de HF liquide et entraînement par un flux d'azote (N2) jusqu'au réacteur.
- Le HF gazeux, quelle que soit la méthode ci-dessus utilisée, est de préférence mélangé à un flux d'azote pur afin de contrôler la concentration en HF dans le réacteur. Ce mélange entre HF gazeux et N2 pur est réalisé soit in-situ dans le réacteur, soit en amont du réacteur dans une chambre de mélange.
- l'étape de retrait de la couche diélectrique modifiée comprenant un retrait des résidus non-volatiles par un nettoyage humide ou un recuit thermique de sublimation est effectuée exclusivement après l'étape de gravure sèche. Le nettoyage humide ou le recuit thermique de sublimation ne sont pas effectués pendant l'étape de gravure sèche.
- Les paramètres de l'étape de retrait de la couche diélectrique modifiée, notamment le ratio de gaz entre le premier composant et le deuxième composant utilisé lors de la gravure sèche, sont prévus de sorte à ce que la couche diélectrique modifiée puisse être gravée de manière sélective vis-à-vis de la couche en un matériau semi-conducteur et vis-à-vis de la couche diélectrique non modifiée.
- Le premier composant est généré par évaporation à partir d'une source liquide ou à partir d'une bouteille pressurisée.
- La mise en présence est réalisée dans un réacteur chimique.
- Le réacteur comprend une enceinte. La mise en présence est réalisée à température ambiante et pression atmosphérique ou est réalisée à température supérieure à la température ambiante et à pression inférieure à la pression atmosphérique.
- Le premier composant est constitué uniquement de HF.
- Le mélange gazeux comprend un deuxième composant à base d'un gaz inerte, choisi parmi l'azote (N2) et/ou l'argon (Ar).
- Le ratio de gaz entre le premier composant et le deuxième composant est compris entre 1 :25 et 1 :1.
- La gravure sèche est effectuée sous une température comprise entre 15°C et 80°C, une pression comprise entre 40 Torr à 760 Torr, pendant une durée allant de quelques secondes à quelques minutes.
- Le retrait de résidus non-volatiles est effectué après la gravure sèche.
- Le retrait de résidus non-volatiles comprend un recuit effectué à une température comprise entre 200°C et 400°C.
- Le recuit est effectué sous une faible pression comprise entre 10.10⁻³ Torr et 2 Torr.
- Le recuit est effectué pendant un temps compris entre 60 et 600 secondes.
- Le retrait de résidus non-volatiles comprend un nettoyage humide à base d'eau dé-ionisée.
- Préalablement à l'étape de retrait de la couche diélectrique modifiée, un recuit thermique sous vide, à une température supérieure à 100°C.
- La couche diélectrique est formée d'un ou plusieurs matériaux diélectriques dont la constante diélectrique k est inférieure ou égale à 7.
- La couche diélectrique est une couche de nitrure.
- La couche diélectrique est une couche à base de silicium (Si).
- Le matériau de la couche diélectrique est pris parmi : le SiCO, le SiC, le SiCN, le SiON, le SiOCN, le SiCBN, le SiOCH.
- Le matériau semi-conducteur est du silicium et l'étape de retrait de la couche diélectrique modifiée est effectuée en partie au moins par gravure sèche sélectivement au silicium (Si) et/ou à l'oxyde de silicium (SiO2).
- Une unique étape de modification est effectuée de sorte à modifier la couche diélectrique dans toute son épaisseur sur toutes les surfaces parallèles au plan d'un substrat sur lequel repose la grille et à ne pas modifier la couche diélectrique dans toute son épaisseur sur les surfaces perpendiculaires à ce plan.
- La couche en un matériau semi-conducteur est pris parmi: le silicium (Si), le germanium (Ge), le silicium-germanium (SiGe) et dans lequel les ions légers sont pris parmi l'hélium (He) et/ou l'hydrogène (H2) et/ou l'ammoniac (NH3).
- Les ions légers sont à base d'hydrogène et le débit des ions légers à base d'hydrogène (H) est compris entre 10 et 500 sccm (centimètre cube par minute), les ions à base d'hydrogène (H) étant pris parmi : H, H+, H2+, H3+.
- Les ions légers sont à base d'hélium et le débit des ions légers à base d'hélium (He) est compris entre 50 et 500 sccm.
- L'étape de modification de la couche diélectrique est réalisée avec une puissance de polarisation ou puissance de source comprise entre 20V (volt) et 500V, avec une pression comprise entre 5 mTorr (milliTorr) et 100 mTorr, à une température comprise entre 10°C et 100°C, pendant une durée de quelques secondes à quelques centaines de secondes.
- L'étape de modification de la couche diélectrique réalisée à partir d'un plasma modifie la couche diélectrique de manière continue depuis la surface de la couche diélectrique et sur une épaisseur comprise entre 1 nm (nanomètre) et 30 nm, de préférence comprise entre 1 nm et 10 nm.
- Le transistor est un transistor de type FDSOI ou de type FinFET.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a à 1d montrent, d'une part, une vue en coupe d'un exemple de transistor MOSFET de type FDSOI en cours de réalisation et, d'autre part, illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
Les FIGURES 2a à 2d illustrent les étapes d'un exemple de procédé selon l'invention appliqué à la réalisation de transistors de type FDSOI.
La FIGURE 3 illustre un graphe représentant le taux de gravure d'une couche d'oxyde de silicium en fonction du pourcentage d'alcool présent.
La FIGURE 4 résume les étapes d'un exemple de procédé de l'invention destinées à former des espaceurs et qui n'induisent pas ou tout au moins limitent les défauts décrits dans les figures 1b à 1d.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte » ou « sous-jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

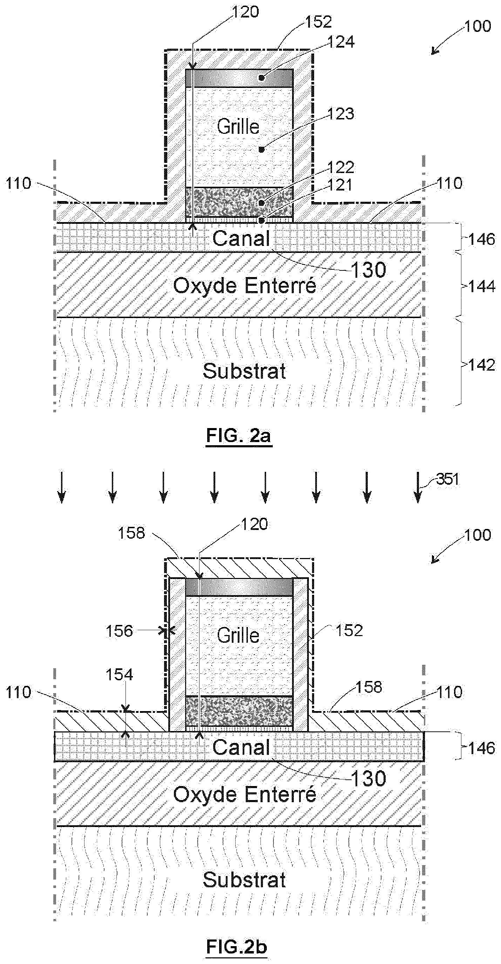

Les **figures 2a à 2d** décrivent les étapes d'un exemple détaillé d'un procédé selon l'invention appliqué à la réalisation de transistors de type FDSOI. Les principes de ces étapes peuvent également s'appliquer à la formation d'espaceurs sur les flancs d'une grille d'un autre type de transistor.

La **figure 2a** illustre l'étape de dépôt d'une couche diélectrique 152, d'épaisseur préférentiellement sensiblement uniforme, sur toutes les surfaces, verticales et horizontales, des dispositifs en cours de fabrication. Cette étape, se fait de préférence à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression sous atmosphérique permet en effet un dépôt uniforme sur toutes les surfaces quelle que soit leur orientation.

Quoi que cela ne soit pas nécessaire à la compréhension du procédé de l'invention, on notera que l'électrode de grille est dans cet exemple composée, à ce stade, du procédé de plusieurs couches pour certains types de transistors. Outre la couche de silicium polycristallin 123, on retrouve, dans l'empilement des couches formant la grille 120, tout d'abord la mince couche isolante d'oxyde de grille 121 à travers laquelle un champ électrique va pouvoir se développer pour créer le canal 130 de conduction sous-jacent entre source et drain, quand une tension électrique suffisante est appliquée sur la grille. Dans les transistors MOSFET les plus récents, il est mis en oeuvre une technologie qualifiée du vocable anglais de « high-k/metal gate » c'est-à-dire que la couche isolante 121 est faite d'un matériau isolant à haute permittivité (high-k) couverte par une grille métallique (metal gate) représentée par la couche 122. Cette technologie a été développée notamment pour réduire les courants de fuite à travers la grille qui devenaient beaucoup trop importants en raison de la diminution de l'épaisseur de la couche isolante 121 jusqu'à des dimensions atomiques. À ce stade, l'empilement de couches de la grille comprend aussi un masque dur 124 de protection qui sera enlevé ultérieurement pour permettre la reprise de contact sur cette électrode. Ce masque dur, qui reste en place après gravure de la grille, est typiquement fait d'oxyde de silicium (SiO2). Son rôle est de protéger le sommet de la grille de tout dommage lors de la gravure des espaceurs.

De préférence, la structure comprend également des tranchées d'isolation (STI) traversant la couche de matériau semi-conducteur 146 formant le canal jusqu'à parvenir au moins jusqu'à une couche isolante sous-jacente telle que la couche d'oxyde enterré 144. Ces tranchées (non illustrées sur les figures) sont typiquement faites de SiO2.

De préférence, la couche isolante 121 est disposée au contact de la couche 146 en un matériau semi-conducteur, formant le canal de conduction. De préférence, la couche 122 est disposée au contact de la couche 121. De préférence, la couche 123 est disposée directement au contact de l'oxyde de grille formée par la couche 121, si la couche 122 est absente ou est disposée directement au contact de la couche 122. De préférence, la couche diélectrique 152 est disposée directement au contact de la couche 123 au niveau des flancs de la grille. De préférence, la couche diélectrique 152 est disposée directement au contact de la couche 146 en un matériau semi-conducteur destinée à former le canal de conduction.

Selon un mode de réalisation, la couche diélectrique 152 est à base de nitrure. Selon un mode de réalisation, la couche diélectrique 152 de nitrure a une épaisseur comprise entre 5 et 20 nm, et typiquement de l'ordre de 10 nm. A titre d'exemple, la couche diélectrique 152 est à base de nitrure de silicium (SiN). La couche diélectrique 152 peut également être choisie parmi l'oxycarbure de silicium (SiCO), le carbure de silicium (SiC), le carbonitrure de silicium (SiCN), l'oxycarbonitrure de silicium (SiOCN), le SiCBN, l'oxycarbure de silicum hydrogéné (SiOCH).

Selon un autre mode de réalisation, la couche diélectrique 152 comprend un matériau diélectrique à faible permittivité ε (la permittivité est notée epsilon) ou à faible constante diélectrique k, avec de préférence k inférieur ou égal à 7. Ainsi, la présente invention n'est pas limitée à une couche diélectrique formée à base de nitrure. La présente invention n'est, par ailleurs, pas non plus limitée à une couche diélectrique de nitrure de silicium (SiN).

La présente invention s'étend avantageusement à tout espaceur comprenant un matériau diélectrique à faible permittivité ε (dit « low-k » en anglais). On entend par « permittivité d'un matériau », au niveau microscopique, la polarisabilité électrique des molécules ou atomes constituant ledit matériau. La permittivité d'un matériau est une grandeur tensorielle (la réponse du matériau peut dépendre de l'orientation des axes cristallographiques du matériau), qui se réduit à un scalaire dans les milieux isotropes. La constante diélectrique est notée k dans le domaine des circuits intégrés et des semi-conducteurs, par exemple. Les matériaux dits « low-k » sont des diélectriques à faible permittivité. Ils sont utilisés comme isolants entre les interconnexions métalliques pour diminuer le couplage entre celles-ci.

Dans un mode de réalisation, la couche diélectrique 152 présente ou comprend un matériau présentant une constante diélectrique inférieure à 4 et de préférence inférieure à 3.1 et de préférence inférieure ou égale à 2, ce qui permet ainsi de réduire la capacité parasite pour éventuellement améliorer la performance du transistor. Par exemple, comme indiqué ci-dessus le matériau de la couche diélectrique 152 est pris parmi : le SiCO, le SiC, le SiCN, le SiOCN, le SiON, le SiCBN, le SiOCH. Cela permet de réduire la capacité parasite et d'améliorer en conséquence la performance du transistor.

De manière préférentielle mais uniquement facultative, le procédé de l'invention comprend une étape facultative de réduction de la constante diélectrique de la couche diélectrique 152. Selon un mode de réalisation avantageux, la réduction de la constante diélectrique est obtenue lors de l'étape de dépôt de la couche diélectrique 152.

Selon un mode de réalisation, la réduction de la constante diélectrique comprend l'introduction dans la couche diélectrique 152 en formation de précurseurs qui forment des liaisons réduisant la polarisabilité de la couche diélectrique 152. Ces précurseurs sont choisis de manière à générer des liaisons moins polaires que le nitrure de silicium, telles que le Si-F, le SiOF, le Si-O, le C-C, le C-H, et le Si-CH3.

Selon un autre mode de réalisation, alternatif ou combinable au précédent, la réduction de la constante diélectrique comprend l'introduction dans la couche diélectrique 152 en formation d'une porosité.

La **figure 2b** illustre l'étape suivante de l'invention appliquée à la réalisation de transistors FDSOI dans laquelle on procède directement à une modification 430 de la couche diélectrique 152 que l'on vient de déposer. Optionnellement, cette opération pourra avoir été précédée d'une gravure 420 « principale », par exemple une gravure sèche conventionnelle de type CH3F/O2/He.

L'étape de modification 430 de la couche diélectrique 152 telle que déposée, ou de la couche restante après une première gravure conventionnelle, se fait par implantation 351 d'espèces légères également désignées ions légers. Dans le cadre de la présente invention, ces ions sont des ions à base d'hydrogène (H) et/ou à base d'hélium (He).

Les ions à base d'hydrogène (H) sont par exemple pris parmi : H, H+, H2+, H3+.

Avantageusement, ces espèces peuvent être prises seules ou en combinaison. Par exemple, les chimies possibles pour l'implantation sont : H, He, NH3, He/H2, He/NH3. Ces ions peuvent être implantés dans un matériau à graver, sans provoquer de dislocation de sa structure atomique telle qu'elle entraînerait une pulvérisation de ce dernier.

On entend par « ions légers » des ions provenant de matériaux dont le numéro atomique dans la classification périodique des éléments est faible. D'une façon générale tous les éléments que l'on peut implanter dans le matériau à graver, sans provoquer de dislocation de sa structure atomique telle qu'elle entraînerait une pulvérisation de ce dernier, et donc sans re-dépôt du matériau gravé sur les parois du réacteur ou les motifs en cours de gravure eux-mêmes, sont susceptibles de convenir.

L'invention permet ainsi une gravure fortement anisotrope.

De manière particulièrement avantageuse, l'implantation d'espèces légères est favorisée par l'incorporation dans le plasma d'un deuxième composant permettant la dissociation des ions légers et donc l'augmentation de la densité d'ions légers dans le plasma et l'augmentation de la dose implantée.

Avantageusement, les paramètres d'implantation, en particulier l'énergie communiquée aux ions, la durée et la dose d'implantation sont prévus de sorte que la couche diélectrique modifiée 158 puisse être gravée sélectivement par rapport à la couche 146 en un matériau semi-conducteur.

Avantageusement, ces paramètres sont également réglés de manière à ce que la couche diélectrique modifiée 158 puisse être gravée sélectivement par rapport à la portion non modifiée de la couche diélectrique 152.

Avantageusement, ces paramètres sont également réglés de manière à ce que la couche diélectrique modifiée 158 puisse être gravée sélectivement par rapport à une couche faite d'un oxyde typiquement un oxyde dudit matériau semi-conducteur, cette dernière formant par exemple une couche d'oxyde de grille. Typiquement, la gravure est sélective du matériau diélectrique modifié par implantation d'hydrogène vis-à-vis de l'oxyde de silicium.

L'implantation s'effectue, selon un exemple non limitatif de l'invention, dans un plasma à base d'hydrogène gazeux (H2). De manière plus générale, tous les composants gazeux, pouvant par dissociation libérer les ions légers cités précédemment, peuvent être utilisés dans le plasma. On notera ici que cette étape de modification 430 de la couche diélectrique 152 à graver peut se pratiquer de nombreuses façons différentes en adaptant toutes sortes de moyens couramment employés par l'industrie de la microélectronique. On utilise notamment des réacteurs de gravure standard dans lesquels on peut réaliser des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication. Enfin, l'implantation peut aussi se faire dans un implanteur standard où l'on accélère les ions dans un champ électrique pour obtenir leur implantation dans un solide.

L'opération de modification est avantageusement très anisotrope pour la réalisation des espaceurs sur les flancs des grilles en raison de la directionnalité des ions du plasma ou de l'implanteur. Elle affecte donc préférentiellement les surfaces horizontales, c'est-à-dire toutes les surfaces parallèles au plan du substrat 142. L'épaisseur modifiée sur les surfaces horizontales 154 est ainsi nettement plus importante que sur les surfaces verticales 156 c'est-à-dire sur toutes les surfaces perpendiculaires au plan du substrat 146 élaboré, sur lequel est disposée la grille. Avantageusement, l'implantation selon la présente invention permet de ne pas attaquer les surfaces verticales. Ainsi, selon un mode de réalisation préféré, l'épaisseur modifiée sur les surfaces verticales 156 est quasi-nulle, de préférence de l'ordre de 1 à 3 nanomètres.

Ce plan est perpendiculaire au plan de la coupe représentée sur les figures 2a à 2d. Le substrat 142 élaboré forme de préférence une plaque (ou « wafer » en anglais) avec deux faces parallèles. Il se présente par exemple sous la forme d'un disque, d'un carré, d'un polygone, etc. La couche mince 146, la couche d'oxyde enterrée 144 et le substrat massif 142 sont disposés selon des plans parallèles. Ainsi, une surface sera qualifiée d'horizontale si elle est parallèle au plan de la couche ou des couches formant le substrat 146, sur lequel est formée la grille et une surface sera qualifiée de verticale si elle est perpendiculaire à ce même plan.

Typiquement, une épaisseur 154 de 10 nm sur les surfaces horizontales peut être modifiée au cours de cette opération. Une épaisseur 156 de la couche 152 allant de 1 à 3 nm est toutefois également modifiée sur les surfaces verticales quelles que soient les conditions du plasma. Ces surfaces verticales par rapport au plan du substrat 146 sont donc parallèles aux flancs de la grille. Les épaisseurs modifiées dépendent des conditions de mise en oeuvre, notamment des moyens employés (plasma ou implanteur) et aussi du fait que l'on désire obtenir la gravure des espaceurs en une seule étape globale de modification et de gravure ou qu'au contraire on répète ces opérations jusqu'à obtenir une gravure complète.

Ainsi, en fonction des mises en oeuvre particulières du procédé de l'invention et de l'épaisseur initiale de la couche diélectrique 152, l'étape de modification de cette couche peut affecter la totalité de cette couche où, comme représenté dans l'exemple de la figure 2b, une partie seulement de celle-ci. Dans ce cas particulier, le matériau est modifié sur toute son épaisseur mais uniquement au niveau des zones horizontales 154. Dans ce cas, l'étape de modification 430 et l'étape suivante de retrait 440 de la couche modifiée décrite ci-après pourront être répétées jusqu'à enlèvement complet du matériau diélectrique de la couche diélectrique modifiée 158 sur toutes les surfaces horizontales.

L'implantation par plasma a pour avantage de permettre une implantation de manière continue dans un volume s'étendant dès la surface de la couche implantée. En outre, l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur d'une couche diélectrique 152, typiquement comprise entre 1 et 10 nm et plus généralement entre 1 et 30 nm.

L'étape de modification réalisée à partir d'un plasma modifie la couche diélectrique 152 de manière continue depuis la surface de la couche diélectrique 152 et sur une épaisseur comprise entre 1 nm et 30 nm et de préférence entre 1 nm et 10 nm.

Selon un mode de réalisation particulièrement avantageux, la modification 430 par implantation de la couche diélectrique 152 et le retrait 440 de la couche diélectrique modifiée 158 sont réalisés dans un même équipement: la modification dans un réacteur plasma et le retrait dans un réacteur chimique avec HF gazeux. La modification de la couche diélectrique 152 à retirer réalisée par une implantation par plasma permet ainsi d'effectuer la modification de la couche diélectrique 152 et la gravure sèche dans une même chambre de la couche diélectrique modifiée 158 ce qui est très avantageux en termes de simplification, de temps et de coût du procédé.

De manière particulièrement avantageuse, la modification de la couche diélectrique 152 par implantation d'ions légers, des ions à base d'hydrogène (H), permet d'améliorer considérablement la sélectivité de cette couche diélectrique modifiée 158 par rapport à la couche 146 en un matériau semi-conducteur, typiquement du silicium. Cette implantation fait également que l'épaisseur de la couche diélectrique modifiée 158 se grave plus rapidement que celle de la couche diélectrique non modifiée 152.

De préférence, la modification de la couche diélectrique 158 conserve une épaisseur de diélectrique non modifié 152 sur les flancs de la grille. Cette épaisseur est conservée, au moins en partie, lors de la gravure sélective. Elle définit alors des espaceurs de grille.

De préférence, les paramètres de l'implantation, notamment l'énergie d'implantation des ions légers issus du premier composant et la dose implantée, sont prévues de sorte que la couche diélectrique modifiée 158 puisse être gravée de manière sélective vis-à-vis du matériau de la couche 146 en un matériau semi-conducteur et vis-à-vis de la couche diélectrique non modifiée 152.

De préférence, une unique étape de modification est effectuée de sorte à modifier la couche diélectrique 152 dans toute son épaisseur sur toutes les surfaces parallèles au plan d'un substrat sur lequel repose la grille et à ne pas modifier la couche diélectrique 152 dans toute son épaisseur sur les surfaces parallèles à la direction privilégiée d'implantation.

Avantageusement, l'implantation est effectuée de manière à modifier toute l'épaisseur de la couche diélectrique 152 en dehors de la couche diélectrique 152 disposée sur les flancs de la grille. Ainsi, le retrait 440 (comprenant avantageusement une gravure sèche 441 et un retrait de résidus 442 en surface) retire toute la couche diélectrique modifiée 158 à l'exception d'une partie au moins de la couche diélectrique non modifiée 152 située sur les flancs de la grille.

Avantageusement, l'implantation modifie la couche diélectrique 152 depuis sa surface et jusqu'à une profondeur correspondant à une partie au moins de son épaisseur. De préférence, l'implantation modifie la couche diélectrique 152 de manière ininterrompue depuis la surface.

Selon un mode de réalisation particulier, le procédé comprend une unique étape de modification 430 effectuée de sorte à modifier la couche diélectrique 152 dans toute son épaisseur sur toutes les surfaces parallèles au plan d'un substrat sur lequel repose la grille et à ne pas modifier la couche diélectrique 152 dans toute son épaisseur sur les surfaces perpendiculaires à ce plan. Ces surfaces perpendiculaires à ce plan, c'est-à-dire perpendiculaire à la couche 146 en un matériau semi-conducteur formant un canal de conduction ou au substrat massif sont typiquement parallèles aux flancs de la grille du transistor. Ainsi, suite à cette unique étape de modification 430, un retrait 440 (comprenant avantageusement une gravure sèche 441 et un retrait de résidus 442 en surface) sélectif de la couche diélectrique modifiée 158 permet de retirer la couche diélectrique sur toutes les surfaces exceptées sur celles parallèles aux flancs de la grille.

Selon un autre mode de réalisation, le procédé comprend plusieurs séquences comprenant chacune une étape de modification 430 et une étape de retrait 440. Au cours d'au moins l'une des étapes de modification 430, seule une partie de l'épaisseur de la couche diélectrique 152 est modifiée. Avantageusement, les séquences sont répétées jusqu'à disparition de la couche diélectrique 152 sur toutes les surfaces parallèles au plan d'un substrat sur lequel repose la grille. Seules les faces parallèles aux flancs de la grille conservent une épaisseur de diélectrique, cette épaisseur n'ayant pas fait l'objet de modification par implantation.

Selon un mode de réalisation avantageux, la couche diélectrique 152 est disposée directement au contact de la couche 146 en un matériau semi-conducteur. De préférence la couche diélectrique 152 est disposée directement au contact de la grille qui est de préférence formée dans un matériau semi-conducteur.

Avantageusement, l'implantation en particulier son énergie, la concentration et la nature des ions légers, la dose utilisée et la durée du procédé d'implantation, sont prévues de sorte que la couche diélectrique modifiée 158 puisse être gravée de manière sélective vis-à-vis du reste de la couche diélectrique, c'est-à-dire à la couche diélectrique non modifiée 152.

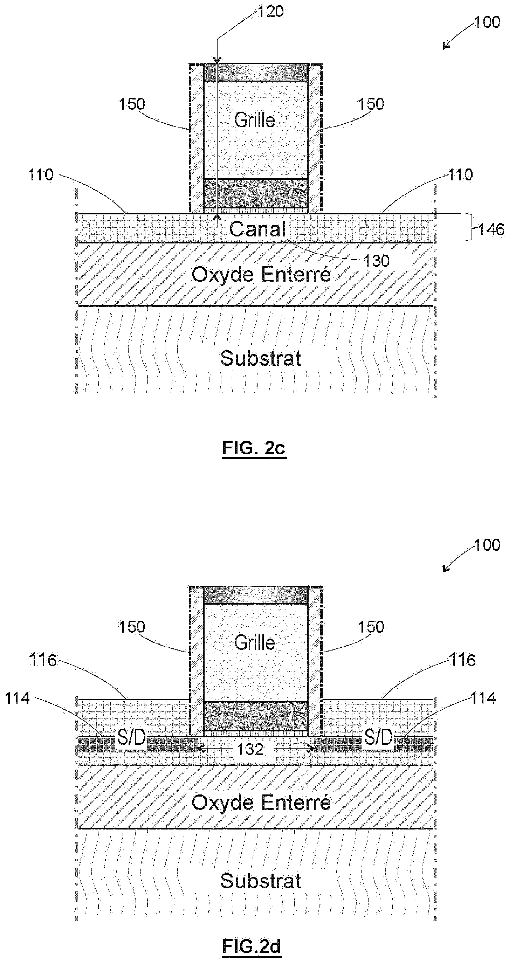

La **figure 2c** illustre le résultat final de l'étape suivante après avoir procédé à la gravure, c'est-à-dire au retrait 440 de la couche diélectrique modifiée 158 et possiblement répété, d'une part, l'opération de modification décrite dans la figure précédente, et d'autre part, l'opération de retrait de la couche diélectrique modifiée 158.

Selon un mode de réalisation, préalablement au retrait de la couche diélectrique modifiée, on réalise un (pré-)recuit 443 à pression atmosphérique ou sous vide, à une température de préférence supérieure à 100 °C pour éliminer toute l'humidité à la surface de la plaque. Le temps d'attente entre le pré-recuit 443 et la gravure sèche 441 à base d'acide fluorhydrique (HF) gazeux doit être maintenu à un minimum. A titre préféré, le pré-recuit 443 et la gravure sèche 441 à base d'acide fluorhydrique HF doivent être effectués dans le même outil.

Le procédé selon la présente invention comprend un retrait de la couche diélectrique modifiée 158 consistant, comme déjà mentionné, à recourir à une séquence d'étapes. Une première étape comprenant une gravure sèche 441 réalisée par mise en présence d'un mélange gazeux comprenant au moins un premier composant à base d'acide fluorhydrique (HF) et une deuxième étape comprenant un retrait de résidus non-volatiles 442 présents à la surface de la plaque (et notamment à la surface de la couche diélectrique modifiée 158).

La gravure sèche 441 est de préférence réalisée dans un outil de gravure capable d'injecter à la fois l'acide fluorhydrique gazeux (généré soit par évaporation à partir d'une source liquide, soit à partir d'une bouteille sous pression) et le gaz inerte (par exemple de l'azote (N2) ou de l'argon (Ar)) pour contrôler la concentration d'acide fluorhydrique dans la chambre du réacteur et par conséquent le taux de gravure. Les débits pour chaque flux de gaz doivent être préférentiellement contrôlés indépendamment. L'outil peut être utilisé pour graver aussi bien une plaque unique qu'un lot de plaques. L'outil de gravure peut avantageusement fonctionner à pression et température ambiantes et/ou à basse pression et/ou à haute température.

La mise en présence est réalisée de préférence dans un simple réacteur chimique : une enceinte hermétique dans laquelle les réactifs sont introduits et qui fonctionne soit à température ambiante et pression atmosphérique, soit à température supérieure à l'ambiante et à pression inférieure à la pression atmosphérique. La mise en présence n'est avantageusement pas faite dans un réacteur plasma, qui ne présenterait aucun avantage par rapport au réacteur chimique simple. Le HF gazeux est disponible en bouteille et peut donc être directement injecté dans le réacteur après détente à la pression à laquelle le réacteur fonctionne. Le HF gazeux peut aussi être généré par évaporation de HF liquide et entraînement par un flux d'azote jusqu'au réacteur. Le HF gazeux, quelle que soit la méthode ci-dessus utilisée, est mélangé à un flux d'azote pur afin de contrôler la concentration en HF dans le réacteur. Ce mélange entre HF gazeux et N2 pur est réalisé soit in-situ dans le réacteur, soit en amont du réacteur dans une chambre de mélange.

La gravure sèche 441 permet avantageusement de retirer une épaisseur de la couche diélectrique modifiée 158 comprise entre 1 nanomètre et quelques dizaines de nanomètres. Préférentiellement, le mélange gazeux utilisé lors de la gravure sèche comprend un deuxième composant. Le deuxième composant est de préférence un gaz inerte, par exemple choisi parmi l'azote ou l'argon. L'emploi d'un gaz inerte permet d'éviter toute autre réaction chimique parasite qui pourrait nuire aux sélectivités de gravure aux autres matériaux (SiN non-modifié, SiO2, semiconducteur). Avantageusement, le deuxième composant permet de contrôler la concentration de HF. Le deuxième composant, de préférence un gaz inerte, permet la dilution à la concentration souhaitée du HF. Dans le cas de l'utilisation de HF pur, on perdrait la sélectivité à l'oxyde de silicium.

Les paramètres de la gravure sèche 441, et notamment le ratio de gaz entre le premier composant et le deuxième composant, sont prévus de sorte à ce que la couche diélectrique modifiée 158 puisse être gravée de manière sélective vis-à-vis de la couche 146 en un matériau semi-conducteur et vis-à-vis de la couche diélectrique non modifiée 152.

De préférence, le ratio de gaz entre le premier composant et le deuxième composant est compris entre 1 :25 et 1 :1. Le premier composant est avantageusement à base d'acide fluorhydrique et le deuxième composant est avantageusement à base d'un gaz inerte. De préférence, le gaz inerte (soit le deuxième composant) est choisi parmi l'argon (Ar) et l'azote (N2). La teneur en gaz inerte est configurée de sorte à ajuster le ratio et, par conséquent, le taux de gravure. Avantageusement, l'azote est préféré à l'argon pour un procédé de réalisation moins coûteux. La gravure sèche est de préférence réalisée sous une température comprise entre 15°C et 80°C, une pression comprise entre 40 Torr et 760 Torr, pendant une durée allant de quelques secondes à quelques minutes (en fonction de l'épaisseur de la couche diélectrique modifiée 158 à retirer).

La gravure sèche transforme en résidus non-volatiles ou sels solides la couche diélectrique modifiée 158. Avantageusement, le HF gazeux est disponible en bouteille et peut donc être directement injecté dans le réacteur après détente à la pression à laquelle le réacteur fonctionne. Le HF gazeux peut aussi être généré par évaporation de HF liquide et entraînement par un flux d'azote jusqu'au réacteur. Le HF gazeux, quelle que soit la méthode ci-dessus utilisée, est mélangé à un flux d'azote pur afin de contrôler la concentration en HF dans le réacteur. Ce mélange entre HF gazeux et N2 pur est réalisé soit in-situ dans le réacteur, soit en amont du réacteur dans une chambre de mélange.

Avantageusement, on réalise un retrait 442 de résidus non-volatiles afin de retirer tout résidu non-volatile présent à la surface de la plaque et formé lors de la gravure sèche. Avantageusement, la dissolution des résidus non-volatiles sous forme de sels solides ne se forme que sur le volume du matériau de la couche diélectrique modifiée 158.
Avantageusement, le retrait 442 de résidus non-volatiles est effectué après la gravure sèche 441 de sorte à retirer, par sublimation, les résidus formés lors de la gravure sèche 441 à base d'acide fluorhydrique gazeux. Dans ce mode de réalisation, le retrait de résidus non-volatiles peut, selon une alternative, comprendre un recuit thermique effectué sous une faible pression comprise entre 10.10⁻³ Torr et 2 Torr. Selon un exemple non limitatif de l'invention, le recuit est réalisé dans un environnement comprenant de l'azote et de l'hydrogène (4%), à une température de 200°C, sous une pression de 1.5 Torr, dont le débit est de 2000 sccm, pendant une durée de 180 secondes. De manière particulièrement avantageuse, à l'issue de cette étape de retrait 442 de résidus non-volatiles, les résidus sont volatilisés, laissant une surface exempte de tout résidu.
Selon une alternative, le retrait 442 de résidus non-volatiles peut comprendre un nettoyage humide à base d'eau déionisée. Pour ce faire, selon un mode de réalisation non limitatif, la plaquette est immergée dans un bain comprenant de l'eau déionisée, pendant une durée d'environ 10 minutes, avec une re-circulation du flux. Selon un autre mode de réalisation, on « asperge » à l'aide d'un spray comprenant une solution d'eau déionisée la surface de la plaquette ou du lot de plaquettes. De manière particulièrement avantageuse, à l'issue de cette étape de retrait de résidus non-volatiles, les résidus sont solubilisés, laissant une surface exempte de tout résidu.

L'arrêt de la gravure se fait sur la couche diélectrique non modifiée 152 ou sur le silicium monocristallin de la couche 146 ou encore sur le masque dur 124 au sommet des grilles. On notera ici, en référence au problème décrit dans la figure 1b, qu'il n'y a aucune consommation de silicium due à l'utilisation d'acide fluorhydrique. Par ailleurs, une optimisation de l'étape de modification 430 par implantation d'espèces légères décrite ci-dessus n'entraîne qu'une modification de la couche diélectrique 152 et l'opération de gravure qui suit n'affecte donc pas le silicium sous-jacent. Ainsi, comme représenté, Il n'y a très avantageusement aucune consommation dans les zones S/D 110 de la couche de silicium 146.

À l'issue de ces opérations il ne reste donc de la couche diélectrique 152 initiale que des motifs verticaux, essentiellement sur les flancs de l'empilement de couches qui forment la grille 120. Ils constituent les espaceurs 150 de grille du transistor.

La **figure 2d** illustre la formation des zones de drain et de source d'un transistor de type FDSOI.

A l'issue de la dernière ou unique étape de retrait de la couche diélectrique modifiée 158, c'est-à-dire lorsqu'on a fini de l'enlever sur toutes les surfaces horizontales, on procède à une opération de nettoyage dite « nettoyage humide » le plus souvent qualifiée par son vocable anglais de « wet clean ». Comme on l'a déjà noté précédemment gravure humide et nettoyage humide sont des opérations similaires qui peuvent être avantageusement combinées en une seule opération.

On peut ensuite procéder à la formation des électrodes de source et de drain 110. Comme on l'a déjà mentionné, le dopage qui va délimiter source et drain et donc la longueur du canal 132 peut se faire par implantation ionique avant qu'on ne procède à une croissance épitaxiale sur ces zones afin d'augmenter leur section et diminuer leur résistance. Si le dopage est effectué avant croissance épitaxiale, comme représenté sur la figure 2d, le procédé est dit être « extension first » vocable anglais utilisé pour indiquer que les extensions (de source et de drain sous les espaceurs) sont réalisées en premier, c'est-à-dire avant croissance épitaxiale. Dans le cas contraire qui est dit être « extension last », on procède directement à l'étape de croissance épitaxiale sans dopage préalable. Le dopage des zones source/drain ne se fait qu'après croissance épitaxiale de ces zones. Dans le cas de transistors à canal de type n (nMOS), les dopants implantés sont typiquement l'arsenic (As) ou le phosphore (P). Pour les transistors à canal de type p (pMOS) les dopants sont le bore (B) ou le difluorure de bore (BF2).

Le résultat est illustré sur la figure 2d qui montre les zones source/drain dopées 114 avant croissance épitaxiale des zones source/drain surélevées 116.

Avantageusement, la grille du transistor est située sur un empilement de couches formant un substrat élaboré de type silicium sur isolant (SOI). De préférence, elle est disposée directement au contact de la couche formant le canal de conduction. Avantageusement, l'utilisation de l'invention avec un tel substrat SOI permet de préserver l'intégrité de la couche superficielle de très faible épaisseur qui forme le canal de conduction d'un transistor formé à partir d'un substrat SOI.

Avantageusement, le matériau semi-conducteur est du silicium. Avantageusement, la gravure est sélective à l'oxyde de silicium (SiO2). Le matériau semi-conducteur peut également être du germanium (Ge) ou du silicium-germanium SiGe. L'étape de retrait de la couche diélectrique modifiée est effectuée par gravure, de préférence à l'aide de HF gazeux ; ce qui permet de manière particulièrement avantageuse une gravure sélective au Ge ou au SiGe et/ou à de l'oxyde de SiGe ou de l'oxyde de Ge.

Selon un mode de réalisation, le transistor est un transistor de type FDSOI. De préférence, le procédé comprend une étape de retrait complet de la couche diélectrique en dehors des flancs et de part et d'autre de la grille pour mettre à nu la couche en un matériau semi-conducteur et une étape de formation de zones de source drain à partir de la couche en un matériau semi-conducteur, par exemple par épitaxie.

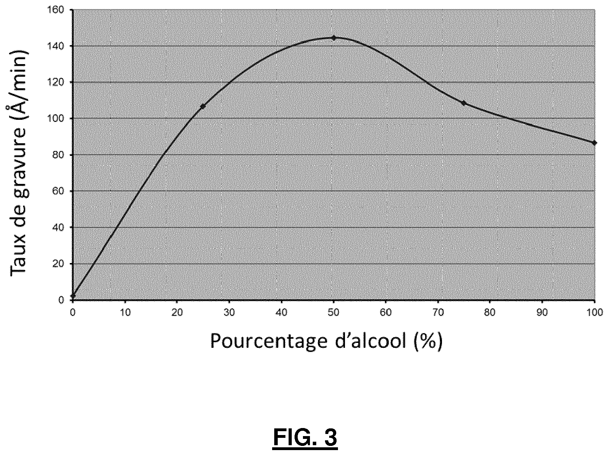

La **figure 3** illustre un graphe représentant le taux de gravure d'une couche d'oxyde de silicium en fonction du pourcentage d'alcool présent dans le flux gazeux introduit dans le réacteur de gravure. Les procédés de gravure à base de mélange gazeux à partir d'acide fluorhydrique ont été développés principalement pour effectuer des gravures de dispositifs de type micro-électro-mécanique (acronyme MEMS en anglais pour « Micro-Electro-Mechanical Systems »), où une couche d'oxyde de silicium sacrificielle doit être éliminée au moyen d'un procédé isotrope. Le procédé, à base d'acide fluorhydrique (HF) en phase gazeuse, présente de grands avantages comparé à un procédé à base d'acide fluorhydrique (HF) en phase liquide. En particulier, utiliser un procédé en phase gazeuse permet d'éliminer les forces de capillarité qui s'établissent entre une surface solide et une phase liquide. En particulier dans le cas des MEMS les forces de capillarité peuvent engendrer un rapprochement des surfaces des parties fixes et mobiles du dispositif, tel que des forces permanentes s'établissent alors (force de Van Der Waals par exemple) immobilisant la partie mobile et rendant le dispositif non-fonctionnel. On parle alors de phénomène de « collage » (« stiction » en Anglais), que le procédé HF gazeux permet d'éviter en grande partie.

Les procédés de gravure à base de mélange gazeux à partir d'acide fluorhydrique ont également été évalués pour effectuer des nettoyages préalablement à une étape d'épitaxie pour des dispositifs de type FEOL. Cependant, ces nettoyages dits « secs » (par exemple, à base d'acide fluorhydrique gazeux) n'ont pas démontré une performance supérieure aux nettoyages traditionnels dits « humides » (par exemple, à base d'acide fluorhydrique liquide) et n'ont donc pas été largement adoptés.

Pour procéder à la gravure d'une couche d'oxyde de silicium (SiO2) par des molécules d'acide fluorhydrique HF, des groupes accepteurs de protons sont nécessaires. Dans le cas d'acide fluorhydrique en phase liquide, l'eau (H2O) joue naturellement ce rôle. Dans le cas d'acide fluorhydrique en phase gazeuse, des groupes hydroxyles sont ajoutés au flux de gaz entrant par co-injection de vapeurs d'alcool (le méthanol, l'éthanol ou l'isopropanol sont le plus couramment utilisés) dans la chambre du graveur avec l'acide fluorhydrique gazeux. Les procédés utilisés pour les gravures des dispositifs MEMS fonctionnent de cette façon. Sans co-injection d'alcool, la vitesse de gravure de l'oxyde de silicium est extrêmement faible comme le montre la figure 3. L'axe des abscisses représente la concentration d'alcool co-injecté, par exemple de l'IPA (Isopropyl alcohol) avec de l'acide fluorhydrique gazeux et l'axe des ordonnées représente le taux de gravure (en Angstrôm/minute).

On observe que plus le pourcentage d'alcool et donc de groupes accepteurs de protons en surface est faible, plus le taux de gravure de la couche d'oxyde de silicium est faible (autrement dit moins la couche SiOx est gravée). Au contraire, plus le pourcentage d'alcool augmente, plus le taux de gravure augmente favorisant la gravure de la couche d'oxyde de silicium.

Ainsi, pour limiter la gravure d'une couche d'oxyde de silicium, il faut éviter de mettre en présence simultanée l'acide fluorhydrique et l'alcool (soit les groupes accepteurs de protons).

Avantageusement, le procédé selon la présente invention, en proposant une séquence d'étapes successives (d'une part, un retrait 442 de résidus non volatiles en surface et, d'autre part, une gravure sèche 441 à base d'acide fluorhydrique) permet d'éviter la mise en présence simultanée d'acide fluorhydrique et de groupes accepteurs de protons (tels que l'alcool, l'eau), et autorise de ce fait une gravure sélective de la couche diélectrique modifiée 158 au regard d'une couche d'oxyde de silicium (dont la gravure quant-à-elle sera limitée).

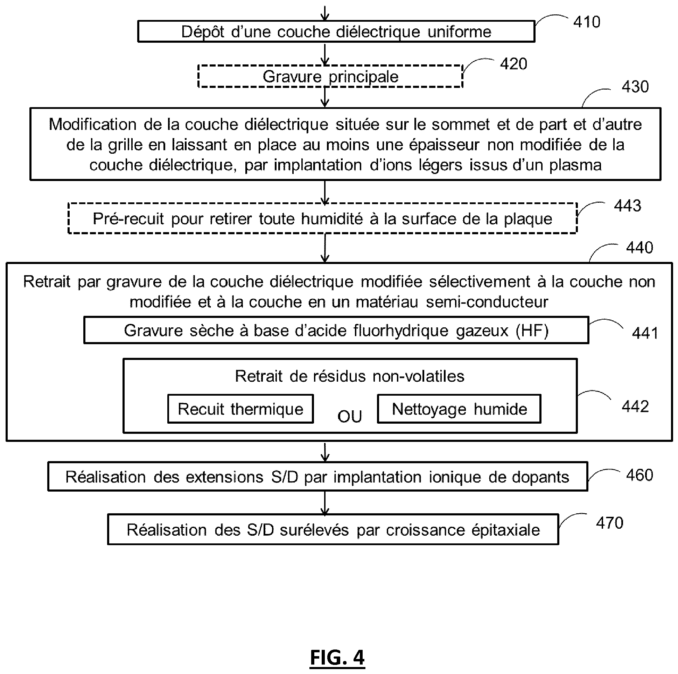

La **figure 4** résume les étapes du procédé de l'invention destinées à former des espaceurs et qui n'induisent aucun des défauts décrits notamment dans les figures 1b, 1c et 1d pour la réalisation de transistors, par exemple FDSOI.

Après dépôt 410 par LPCVD d'une couche diélectrique 152 uniforme sur toutes les surfaces des dispositifs en cours de fabrication, on procède au retrait de ladite couche diélectrique modifiée 158 sur les surfaces qui ne sont pas destinées à former les espaceurs. Ce retrait comprend plusieurs étapes, dont les étapes 430, 440 et optionnellement l'étape 420 préalable.

Ainsi, optionnellement, on procède à une gravure « principale », de préférence une gravure sèche conventionnelle anisotrope 420 de la couche diélectrique modifiée 158. Ceci est typiquement effectué dans un plasma de type CH3F/O2/He décrit précédemment. Dans le cadre de mises en oeuvre spécifiques de l'invention, on peut décider de maintenir ou non l'étape de gravure principale 420, les étapes suivantes s'appliquent alors soit sur la couche diélectrique 152 telle que déposée ou sur la couche restante après qu'une gravure principale a été préalablement effectuée comme dans le procédé standard de gravure des espaceurs.

Comme montré sur la figure 2b, l'étape suivante 430 consiste à modifier de façon anisotrope tout ou partie 154 de la couche diélectrique restante 152 par implantation d'ions légers. Avantageusement, le deuxième composant interagit sur le premier composant afin de dissocier le premier composant et favoriser la création d'ions légers, augmentant ainsi la concentration en ions H et la dose.

Suivant les applications du procédé de l'invention on pourra préférer utiliser un graveur plasma pour l'implantation plasma notamment pour les raisons suivantes : le coût de l'appareillage est moins élevé, les temps de cycle de fabrication peuvent être plus courts puisque l'étape de gravure principale 420 et celle de modification 430 de la couche diélectrique 152 peuvent alors se faire dans le même appareillage sans remise à l'air des dispositifs en cours de fabrication. On notera en particulier que l'étape de modification 430 peut se pratiquer de nombreuses façons différentes en adaptant toutes sortes de moyens couramment employés par l'industrie de la microélectronique, tel qu'à l'aide de tout type graveur, par exemple dans un réacteur ICP de l'anglais « Inductively Coupled Plasma » c'est-à-dire « plasma à couplage inductif », ou dans un réacteur de type CCP de l'anglais « Capacitively Coupled Plasma » c'est-à-dire « plasma à couplage capacitif » qui permet de contrôler l'énergie des ions. On peut aussi utiliser un type de plasma dit par immersion couramment utilisé pour pratiquer une implantation d'espèces en surface d'un dispositif en cours de fabrication.

Pour choisir les paramètres d'implantation l'homme du métier, afin de déterminer le comportement du matériau à graver dans le type de graveur plasma choisi, procédera préalablement de préférence à des essais « pleine plaque » afin d'établir des courbes de comportement. Il en déduira les paramètres de l'implantation, en particulier l'énergie et la dose d'ions, c'est-à-dire le temps d'exposition, à utiliser pour atteindre l'épaisseur voulue de matériau à modifier.

L'étape suivante 440 est celle où l'on pratique le retrait par gravure de la couche modifiée ou tout au moins de l'épaisseur modifiée de la couche diélectrique modifiée 158. Pour éviter les problèmes des procédés traditionnels de gravure des espaceurs décrits dans les figures 1b à 1d, il est nécessaire que la gravure de la couche diélectrique modifiée 158 soit la plus sélective possible par rapport au silicium notamment afin de ne pas attaquer le silicium monocristallin des zones source/drain avec les inconvénients et conséquences décrits précédemment.

Selon un mode de réalisation, préalablement au retrait de la couche diélectrique modifiée, on réalise un (pré-)recuit 443 sous vide, à une température de préférence supérieure à 100 °C pour éliminer toute l'humidité à la surface de la plaque. Le temps d'attente entre le pré-recuit 443 et la gravure sèche 441 à base d'acide fluorhydrique (HF) gazeux doit être maintenu à un minimum. A titre préféré, le pré-recuit 443 et la gravure sèche 441 à base d'acide fluorhydrique HF doivent être effectués dans le même outil.

Le retrait 440 de la couche diélectrique modifiée 158 comprend avantageusement une gravure sèche 441, de préférence, à base d'acide fluorhydrique (HF) pour une couche diélectrique 152, par exemple à base de nitrure de silicium, combinée à un retrait 442 de résidus non-volatiles présents sur la plaque contenant les dispositifs en cours de fabrication. Cela simplifie le procédé et apporte un gain de temps.

L'épaisseur de la couche diélectrique modifiée 158 est typiquement comprise dans une gamme de valeurs allant de 1 nanomètre à quelques dizaines de nanomètres. Les temps de gravure peuvent aller de quelques secondes à quelques minutes. Ils sont évidemment directement dépendants de l'épaisseur de la couche diélectrique qui a été modifiée 158.

À titre d'exemple, pour enlever une épaisseur de 10 nm de la couche diélectrique modifiée 158, il faut former un mélange gazeux dont le ratio des premier et deuxième composants se compose ainsi : 31% d'acide fluorhydrique (HF) gazeux pour 69% d'azote (N2) sec. Un temps de gravure de l'ordre de 2 minutes est requis, à température ambiante et à pression ambiante.

La gravure sèche 441 de la couche diélectrique modifiée 158 sera également aussi sélective par rapport à l'oxyde de silicium. C'est notamment le cas pour pouvoir réaliser des transistors tridimensionnels de type FinFET. Une gravure sèche 441 sélective au silicium et à son oxyde (Si/SiO2), accompagnée d'un retrait 442 de résidus en surface pourra alors être aussi pratiquée pour cette étape de retrait de la couche diélectrique modifiée 158.

Ce mode de réalisation permet d'obtenir, par exemple, une très bonne sélectivité de la gravure du nitrure modifié par rapport au nitrure non modifié et au matériau de la couche 146 en un matériau semi-conducteur non modifié. Avantageusement, les sélectivités sont améliorées grâce au HF gazeux, par rapport au HF liquide. En particulier, la sélectivité est multipliée par 3 sur du nitrure non modifié, par 14 sur de l'oxyde de silicium. Sur un matériau semiconducteur (par exemple, Si, SiGe ou Ge), la sélectivité est infinie.

On remarquera ici qu'il existe des réacteurs de gravure permettant de réaliser une implantation, par exemple d'hydrogène, à partir d'un plasma qui peut être suivi, dans le même système, du retrait de la couche diélectrique modifiée 158 à l'aide d'une gravure sèche comme décrite ci-dessus. Ainsi, il est possible dans ce cas d'enchaîner les cycles de modification 430 et de retrait 440 de la couche diélectrique 152 sélectivement au Si ou SiO2, sans remise à l'air de la plaque. Ceci est une incitation supplémentaire à l'utilisation d'un réacteur de gravure pour mettre en oeuvre l'invention plutôt que d'utiliser un implanteur standard chaque fois que c'est possible.

Comme déjà mentionné les opérations de modification 430 de la couche diélectrique 152 et de retrait 440 de la couche diélectrique modifiée 158 peuvent optionnellement être répétées 450 jusqu'à disparition du matériau diélectrique de la couche diélectrique modifiée 158 sur toutes les surfaces horizontales.

Les étapes suivantes du procédé ne sont pas différentes de celles correspondantes des procédés standard où l'on réalise possiblement les extensions des zones source/drain 460 par implantation ionique de dopants avant croissance épitaxiale des source/drain surélevés 470 de transistors FDSOI.

Le tableau ci-après donne des conditions typiques de mise en oeuvre de l'étape 430 de modification de la couche diélectrique 152 dans le cas d'utilisation d'un réacteur de gravure plasma standard. Ces conditions sont largement dépendantes de l'épaisseur à modifier dans la couche diélectrique 152. Ceci n'est qu'un exemple particulier de mise en oeuvre de l'étape 430 de modification de la couche à graver. Comme déjà mentionné précédemment, d'autres moyens peuvent être utilisés pour l'implantation des espèces légères servant à modifier la couche à graver. Notamment, on pourra utiliser des plasmas à faible ou haute densité ou des plasmas par immersion. Avantageusement, n'importe quel type de dispositif de gravure sèche est potentiellement utilisable et notamment ceux dit ICP de l'anglais « inductively coupled plasma » c'est-à-dire « plasma à couplage inductif » ou encore CCP de l'anglais « capacitively coupled plasma » c'est-à-dire « plasma à couplage capacitive. La possibilité de pulser la source et/ou le bias permet également d'avoir un meilleur contrôle sur la profondeur d'implantation pour de faibles épaisseurs.

| | |
|---|---|
| Réacteur de gravure : | Les valeurs ci-dessous s'appliquent plus particulièrement au type de graveur ICP bien que n'importe quel type de dispositif de gravure sèche est potentiellement utilisable. |
| Épaisseur modifiée : | de 1 nanomètre à quelques dizaines de nanomètres, typiquement 15 nanomètres. |
| Chimie | basée sur une chimie à base d'hydrogène et/ou à base d'hélium telle que H2, NH3 ou une combinaison d'hélium et d'hydrogène, ou d'hélium et de NH3. |
| Débit composant : | |
| - H2 | 10 sccm - 500 sccm (centimètres cube par minute) |
| - He | 50 sccm - 500 sccm |
| - NH3 | 10 sccm - 500 sccm |
| Puissance de la source : | 0 - 2000 W |
| Tension de polarisation : | 20 V - 500 V |
| Fréquence | 100 Hz - 500 kHz (pour le mode pulsé) |
| Cycle opératoire | 10 % - 90% (pour le mode pulsé) |
| Pression: | 5 milli - 100 milli Torr |
| Température : | 10 °C - 100°C |
| Temps : | quelques secondes à quelques centaines de secondes |

A titre d'exemple non limitatif de l'invention, pour modifier une épaisseur de 15 nm de nitrure de silicium dans un graveur de type ICP (TCP RF), en continu, l'énergie ionique (ou tension de polarisation) requise pour un plasma formé à partir d'un composant à base d'hydrogène (H), dont le débit est de 50 sccm, pour une tension de 250V pendant une durée de 60 secondes. Dans ce cas, la pression utilisée est de 10 mTorr et la puissance de la source de 500W.

L'invention n'est pas limitée aux seuls modes et exemples de réalisation décrits ci-dessus, mais s'étend à tous les modes de réalisation entrant dans la portée des revendications.

Le procédé selon la présente invention à base d'acide fluorhydrique gazeux est effectué à température ambiante (c'est-à-dire comprise entre 20°C et 30°C) et à pression atmosphérique 760 Torr. Cependant, contrôler la température du gaz à base de HF de sorte à ce qu'elle soit préférentiellement d'une valeur supérieure à celle de la température ambiante ou/et contrôler la pression de sorte à être préférentiellement inférieure à celle de la pression ambiante conduirai(en)t à obtenir une sélectivité encore plus élevée entre une couche de nitrure de silicium (SiN) et une couche d'oxyde de silicium (SiO2) ou une couche de nitrure de silicium SiN non modifiée, en réduisant la quantité d'humidité sur la surface de la plaquette (en anglais « wafer »).

## Revendications

1. Procédé de formation d'espaceurs d'une grille (150) d'un transistor à effet de champ (100), la grille (150) comprenant des flancs et un sommet et étant située au-dessus d'une couche (146) en un matériau semi-conducteur, au moins une couche en oxyde de silicium (SiO2) formant un masque dur (124) situé sur la grille (150) ou formant une tranchée d'isolation, le procédé comprenant une étape (410) de formation d'une couche diélectrique (152) recouvrant la grille du transistor, le procédé comprenant :
- après l'étape de formation de la couche diélectrique (152), au moins une étape de modification (430) de ladite couche diélectrique (152) par mise en présence de la couche diélectrique (152) avec un plasma créant un bombardement d'ions légers anisotrope selon une direction privilégiée parallèle à des flancs de la grille (120), les conditions du plasma, en particulier l'énergie des ions légers et la dose implantée étant choisies de manière à modifier, par implantation des ions légers, au moins des portions (158) de la couche diélectrique (152) qui sont situées sur un sommet de la grille et de part et d'autre de la grille (120) et qui sont perpendiculaires aux flancs de la grille (120) en conservant des portions de la couche diélectrique (152) recouvrant les flancs de la grille (120) non-modifiées ou non-modifiées sur toute leur épaisseur; les ions légers étant des ions à base d'hydrogène (H) et/ou à base d'hélium (He);
- au moins une étape de retrait (440) de la couche diélectrique modifiée (158) à l'aide d'une gravure sélective de ladite couche diélectrique modifiée (158) vis-à-vis de la couche (146) en un matériau semi-conducteur et vis-à-vis de la couche diélectrique (152) non modifiée ;
**caractérisé en ce que** l'étape de retrait (440) de la couche diélectrique modifiée (158) comprend :
- une gravure sèche (441) réalisée par mise en présence d'un mélange gazeux, de préférence uniquement gazeux, comprenant au moins un premier composant à base d'acide fluorhydrique (HF), l'acide fluorhydrique transformant en résidus non-volatiles à température ambiante la couche diélectrique modifiée (158), ledit mélange gazeux étant exempt de groupes accepteurs de protons,
- uniquement après la gravure sèche (441) : un retrait (442) des résidus non-volatiles à température ambiante par un nettoyage humide ou par un recuit thermique de sublimation.

2. Procédé selon la revendication précédente dans lequel le mélange gazeux comprend un deuxième composant et dans lequel les paramètres de l'étape de retrait (440) de la couche diélectrique modifiée (158), notamment le ratio de gaz entre le premier composant et le deuxième composant utilisé lors de la gravure sèche, sont prévus de sorte à ce que la couche diélectrique modifiée (158) puisse être gravée de manière sélective vis-à-vis de la couche (146) en un matériau semi-conducteur et vis-à-vis de la couche diélectrique (152) non modifiée.

3. Procédé selon l'une quelconque des revendications précédentes dans lequel la gravure sèche (441) est réalisée par mise en présence d'un mélange gazeux comprenant uniquement de l'acide fluorhydrique (HF) et éventuellement un gaz inerte.

4. Procédé selon l'une quelconque des revendications précédentes dans lequel le mélange gazeux comprend un deuxième composant à base d'un gaz inerte, choisi parmi l'azote (N2) et/ou l'argon (Ar).

5. Procédé selon la revendication précédente dans lequel le ratio de gaz entre le premier composant et le deuxième composant est compris entre 1 :25 et 1 :1.

6. Procédé selon l'une quelconque des revendications précédentes dans lequel la gravure sèche (441) est effectuée sous une température comprise entre 15°C et 80°C, une pression comprise entre 40 Torr à 760 Torr, pendant une durée allant de quelques secondes à quelques minutes.

7. Procédé selon l'une quelconque des revendications précédentes dans lequel le retrait (442) de résidus non-volatiles à température ambiante comprend un recuit thermique de sublimation effectué à une température comprise entre 200°C et 400°C.

8. Procédé selon l'une quelconque des revendications précédentes comprenant, préalablement à l'étape de retrait (440) de la couche diélectrique modifiée (158), un recuit thermique sous vide, à une température supérieure à 100°C.

9. Procédé selon l'une quelconque des revendications précédentes dans lequel la couche diélectrique (152) est formée d'un ou plusieurs matériaux diélectriques dont la constante diélectrique k est inférieure ou égale à 7.

10. Procédé selon l'une quelconque des revendications précédentes dans lequel la couche diélectrique (152) est une couche de nitrure, de préférence un nitrure de silicium (SiN) et dans lequel la couche diélectrique (152) est une couche est un matériau pris parmi: le silicium (Si), le germanium (Ge), le silicium-germanium (SiGe).

11. Procédé selon l'une quelconque des revendications 1 à 10 dans lequel le matériau de la couche diélectrique (152) est pris parmi : le SiCO, le SiC, le SiCN, le SiON, le SiOCN, le SiCBN, le SiOCH.

12. Procédé selon l'une quelconque des revendications précédentes, le matériau semi-conducteur étant du silicium (Si) et dans lequel l'étape de retrait (440) de la couche diélectrique modifiée (158) est effectuée en partie au moins par gravure sèche (441) sélectivement au silicium (Si) et/ou à la couche d'oxyde de silicium (SiO2) (121).

13. Procédé selon l'une quelconque des revendications précédentes dans lequel les ions légers sont à base d'hydrogène et le débit des ions légers à base d'hydrogène (H) est compris entre 10 et 500 sccm (centimètre cube par minute), les ions à base d'hydrogène (H) étant pris parmi : H, H+, H2+, H3+ ou dans lequel les ions légers sont à base d'hélium et le débit des ions légers à base d'hélium (He) est compris entre 50 et 500 sccm.

14. Procédé selon l'une quelconque des revendications précédentes, dans lequel le transistor est un transistor de type FDSOI ou de type FinFET.

## Patentansprüche

1. Verfahren zum Bilden von Abstandshaltern eines Gates (150) eines Feldeffekttransistors (100), wobei das Gate (150) Flanken und eine Spitze aufweist und sich über einer Schicht (146) aus einem Halbleitermaterial befindet, wobei mindestens eine Schicht aus Siliziumoxid (SiO2) eine Hartmaske (124) bildet, sie sich auf dem Gate (150) befindet, oder einen Isolationsgraben bildet, wobei das Verfahren einen Schritt (410) des Bildens einer dielektrischen Schicht (152) umfasst, die das Gate des Transistors bedeckt, wobei das Verfahren umfasst:
- nach dem Schritt des Bildens der dielektrischen Schicht (152), mindestens einen Schritt des Modifizierens (430) der dielektrischen Schicht (152) durch Zusammenbringen der dielektrischen Schicht (152) mit einem Plasma, das einen anisotropen Beschuss leichter Ionen in einer bevorzugten Richtung parallel zu Flanken des Gates (120) erzeugt, wobei die Bedingungen des Plasmas, insbesondere die Energie der leichten Ionen und die implantierte Dosis so gewählt werden, dass mindestens Abschnitte (158) der dielektrischen Schicht (152), die sich an einer Spitze des Gates und auf beiden Seiten des Gates (120) befinden und die zu den Flanken des Gates (120) senkrecht sind, durch Implantation der leichten Ionen modifiziert werden, unter Beibehaltung von nicht modifizierten oder in ihrer gesamten Dicke nicht modifizierten Abschnitten der dielektrischen Schicht (152), die die Flanken des Gates (120) bedecken; wobei die leichten Ionen Ionen auf Basis von Wasserstoff (H) und/oder auf Basis von Helium (He) sind;
- mindestens einen Schritt des Entfernens (440) der modifizierten dielektrischen Schicht (158) mit Hilfe eines selektiven Ätzens der modifizierten dielektrischen Schicht (158) gegenüber der Schicht (146) aus einem Halbleitermaterial und gegenüber der nicht modifizierten dielektrische Schicht (152);
**dadurch gekennzeichnet, dass** der Schritt des Entfernens (440) der modifizierten dielektrischen Schicht (158) umfasst:
- ein Trockenätzen (441), das durch Zusammenbringen mit einem gasförmigen, vorzugsweise nur gasförmigen Gemisch ausgeführt wird, das mindestens eine erste Komponente auf Basis von Fluorwasserstoffsäure (HF) umfasst, wobei die Fluorwasserstoffsäure die modifizierte dielektrische Schicht (158) in bei Raumtemperatur nichtflüchtige Rückstände umwandelt, wobei das gasförmige Gemisch frei ist von protonenakzeptierenden Gruppen,
- erst nach dem Trockenätzen (441): ein Entfernen (442) der bei Raumtemperatur nichtflüchtigen Rückstände durch ein Nassreinigen oder durch ein thermisches Sublimationsglühen.

2. Verfahren nach dem vorstehenden Anspruch, wobei das gasförmige Gemisch eine zweite Komponente umfasst, und wobei die Parameter des Schrittes des Entfernens (440) der modifizierten dielektrischen Schicht (158), insbesondere das Gasverhältnis zwischen der ersten Komponente und der zweiten Komponente, das beim Trockenätzen verwendet wird, so vorgesehen werden, dass die modifizierte dielektrische Schicht (158) selektiv gegenüber der Schicht (146) aus einem Halbleitermaterial und gegenüber der nicht modifizierten dielektrischen Schicht (152) geätzt werden kann.

3. Verfahren nach einem der vorstehenden Ansprüche, wobei das Trockenätzen (441) durch Zusammenbringen mit einem gasförmigen Gemisch ausgeführt wird, das nur Fluorwasserstoffsäure (HF) und gegebenenfalls ein Inertgas umfasst.

4. Verfahren nach einem der vorstehenden Ansprüche, wobei das gasförmige Gemisch eine zweite Komponente auf Basis eines Inertgases umfasst, ausgewählt aus Stickstoff (N2) und/oder Argon (Ar).

5. Verfahren nach dem vorstehenden Anspruch, wobei das Gasverhältnis zwischen der ersten Komponente und der zweiten Komponente zwischen 1:25 und 1:1 liegt.

6. Verfahren nach einem der vorstehenden Ansprüche, wobei das Trockenätzen (441) unter einer Temperatur zwischen 15 °C und 80 °C, einem Druck zwischen 40 Torr bis 760 Torr während einer Dauer im Bereich von einigen Sekunden bis einigen Minuten durchgeführt wird.

7. Verfahren nach einem der vorstehenden Ansprüche, wobei das Entfernen (442) von bei Raumtemperatur nichtflüchtigen Rückständen ein thermisches Sublimationsglühen umfasst, das bei einer Temperatur zwischen 200 °C und 400 °C durchgeführt wird.

8. Verfahren nach einem der vorstehenden Ansprüche, das vor dem Schritt des Entfernens (440) der modifizierten dielektrischen Schicht (158) ein thermisches Vakuumglühen bei einer Temperatur von größer als 100 °C umfasst.

9. Verfahren nach einem der vorstehenden Ansprüche, wobei die dielektrische Schicht (152) aus einem oder mehreren dielektrischen Materialien gebildet wird, deren Dielektrizitätskonstante k kleiner oder gleich 7 ist.

10. Verfahren nach einem der vorstehenden Ansprüche, wobei die dielektrische Schicht (152) eine Nitridschicht, vorzugsweise ein Siliziumnitrid (SiN) ist, und wobei die dielektrische Schicht (152) eine Schicht aus einem Material ist, ausgewählt aus: Silizium (Si), Germanium (Ge), Silizium-Germanium (SiGe).

11. Verfahren nach einem der Ansprüche 1 bis 10, wobei das Material der dielektrischen Schicht (152) ausgewählt ist aus: SiCO, SiC, SiCN, SiON, SiOCN, SiCBN, SiOCH.

12. Verfahren nach einem der vorstehenden Ansprüche, wobei das Halbleitermaterial Silizium (Si) ist, und wobei der Schritt des Entfernens (440) der modifizierten dielektrischen Schicht (158) mindestens zum Teil durch Trockenätzen (441) selektiv auf dem Silizium (Si) und/oder auf der Siliziumoxidschicht (SiO2) (121) durchgeführt wird.

13. Verfahren nach einem der vorstehenden Ansprüche, wobei die leichten Ionen auf Basis von Wasserstoff sind und der Durchsatz der leichten Ionen auf Basis von Wasserstoff (H) zwischen 10 und 500 sccm (Kubikzentimeter pro Minute) liegt, wobei die Ionen auf Basis von Wasserstoff (H) ausgewählt sind aus: H, H+, H2+, H3+, oder wobei die leichten Ionen auf Basis von Helium sind und der Durchsatz der leichten Ionen auf Basis von Helium (He) zwischen 50 und 500 sccm liegt.

14. Verfahren nach einem der vorstehenden Ansprüche, wobei der Transistor ein Transistor vom Typ FDSOI oder vom Typ FinFET ist.

## Claims

1. Method for forming spacers of a gate (150) of a field-effect transistor (100), the gate (150) comprising edges and a top and being situated above a layer (146) made of a semi-conductive material, at least one layer made of silicon oxide (SiO₂) forming a hard mask (124) situated on the gate (150) or forming an insulation trench, the method comprising a step (410) of forming a dielectric layer (152) covering the gate of the transistor, the method comprising:
- after the step of forming the dielectric layer (152), at least one step of modifying (430) said dielectric layer (152) by bringing together the dielectric layer (152) with a plasma creating a bombardment of anisotropic light ions according to a favoured direction parallel to the edges of the gate (120), the conditions of the plasma, in particular the energy from the light ions and the dose implanted being selected so as to modify, by implantation of light ions, at least portions (158) of the dielectric layer (152) which are situated on a top of the gate and on either side of the gate (120) and which are perpendicular to the edges of the gate (120) by conserving portions of the dielectric layer (152) covering the edges of the gate (120), not modified or not modified over the whole of the thickness thereof; the light ions being hydrogen-based (H) and/or helium-based (He) ions;
- at least one step of removing (440) the modified dielectric layer (158) using a selective etching of said modified dielectric layer (158) opposite the layer (146) made of a semi-conductive material and opposite the non-modified dielectric layer (152);
**characterised in that** the step of removing (440) the modified dielectric layer (158) comprises:
- a dry etching (441) carried out by bringing together a gaseous mixture, preferably only gaseous, comprising at least one first hydrofluoric (HF) acid-based component, the hydrofluoric acid transforming the modified dielectric layer (158) into non-volatile residue at ambient temperature, said gaseous mixture having no proton-accepting groups,
- only after the dry etching (441): a removal (442) of the non-volatile residue at ambient temperature by a wet cleaning or by a thermal sublimation annealing.

2. Method according to the preceding claim, wherein the gaseous mixture comprises a second component, and wherein the parameters of the step of removing (440) the modified dielectric layer (158), in particular the gas ratio between the first component and the second component used during the dry etching, are provided such that the modified dielectric layer (158) can be etched selectively opposite the layer (146) made of a semi-conductive material and opposite the non-modified dielectric layer (152).

3. Method according to any one of the preceding claims, wherein the dry etching (441) is carried out by bringing together a gaseous mixture only comprising hydrofluoric (HF) acid and possibly an inert gas.

4. Method according to any one of the preceding claims, wherein the gaseous mixture comprises a second inert gas-based component, selected from among nitrogen (N₂) and/or argon (Ar).

5. Method according to the preceding claim, wherein the gas ratio between the first component and the second component is of between 1:25 and 1:1.

6. Method according to any one of the preceding claims, wherein the dry etching (441) is carried out under a temperature of between 15°C and 80°C, a pressure of between 40 Torr and 760 Torr, for a duration going from a few seconds to a few minutes.

7. Method according to any one of the preceding claims, wherein the removal (442) of non-volatile residue at ambient temperature comprising a thermal sublimation annealing carried out at a temperature of between 200°C and 400°C.

8. Method according to any one of the preceding claims, comprising, prior to the step of removing (440) the modified dielectric layer (158), a vacuumed thermal annealing, at a temperature greater than 100°C.

9. Method according to any one of the preceding claims, wherein the dielectric layer (152) is formed of one or more dielectric materials, of which the dielectric constant k is less than or equal to 7.

10. Method according to any one of the preceding claims, wherein the dielectric layer (152) is a nitride layer, preferably a silicon nitride (SiN) layer, and wherein the dielectric layer (152) is a layer made of a material taken from among: silicon (Si), germanium (Ge), silicon-germanium (SiGe).

11. Method according to any one of claims 1 to 10, wherein the material of the dielectric layer (152) is taken from among: SiCO, SiC, SiCN, SiON, SiOCN, SiCBN, SiOCH.

12. Method according to any one of the preceding claims, the semi-conductive material being silicon (Si), and wherein the step of removing (440) the modified dielectric layer (158) is partially achieved at least by dry etching (441) selectively with silicon (Si) and/or with the silicon oxide (SiO₂) layer (121).

13. Method according to any one of the preceding claims, wherein the light ions are hydrogen-based and the flow of the hydrogen-based (H) light ions is of between 10 and 500sccm (cubic centimetres per minute), the hydrogen-based (H) ions being taken from among: H, H⁺, H₂⁺, H₃⁺, or wherein the light ions are helium-based and the flow of the helium-based (He) light ions is of between 50 and 500sscm.

14. Method according to any one of the preceding claims, wherein the transistor is an FDSOI-type or FinFET-type transistor.
